# EUROPÄISCHE PATENTSCHRIFT

(11) **EP 2 603 940 B1**
(45) Veröffentlichungstag und Bekanntmachung des Hinweises auf die Patenterteilung: **26.08.2015**
(21) Anmeldenummer: 11757237.0
(22) Anmeldetag: 05.09.2011
(51) Int. Cl.: H01L 35/32, H01L 35/22, H01L 35/26, H01L 35/30, C04B 35/628, F28D 21/00

(54) **THERMOELEKTRISCHER GENERATOR**
THERMOELECTRIC GENERATOR
GÉNÉRATEUR THERMOÉLECTRIQUE

(30) Priorität: 29.09.2010 DE 102010041652
(43) Veröffentlichungstag der Anmeldung: 19.06.2013
(73) Patentinhaber: Siemens Aktiengesellschaft, 80333 München (DE)
(72) Erfinder: GRÖPPEL, Peter, 91052 Erlangen (DE); LANG, Steffen, 91052 Erlangen (DE); RITZHAUPT-KLEISSL, Eberhard, 91083 Baiersdorf (DE)
(86) Internationale Anmeldenummer: PCT/EP2011/065279
(87) Internationale Veröffentlichungsnummer: WO 2012/045536

(56) Entgegenhaltungen:
- EP-A1- 2 154 734
- EP-A2- 1 515 376
- WO-A1-2009/138412
- JP-A- 2008 028 048
- US-A1- 2008 087 314
- MATSUBARA ICHIRO ET AL: "Fabrication of an all-oxide thermoelectric power generator", APPLIED PHYSICS LETTERS, AIP, AMERICAN INSTITUTE OF PHYSICS, MELVILLE, NY, US, Bd. 78, Nr. 23, 4. Juni 2001 (2001-06-04), Seiten 3627-3629, XP012028210, ISSN: 0003-6951, DOI: 10.1063/1.1376155
- CHOI S M ET AL: "Oxide-based thermoelectric power generation module using p-type Ca3Co4O9 and n-type (ZnO)7In2O3 legs", ENERGY CONVERSION AND MANAGEMENT, ELSEVIER SCIENCE PUBLISHERS, OXFORD, GB, Bd. 52, Nr. 1, 13. August 2010 (2010-08-13), Seiten 335-339, XP027443494, ISSN: 0196-8904, DOI: 10.1016/J.ENCONMAN.2010.07.005 [gefunden am 2010-08-13]

## Beschreibung

Die Erfindung betrifft einen thermoelektrischen Generator, insbesondere einen zur Nutzung der Abwärme von Abgasen mit einer Temperatur kleiner 250°C, wie sie beispielsweise in der Kraftwerkstechnologie anfallen.

So ergibt sich z. B. für ein 800 MW Kohlekraftwerk ein Ausstoß von 3 Mio. m³ Abgas pro Stunde mit einer Temperatur von ca. 150°C.

Teile dieser Energie sollen mittels thermoelektrischer Generatoren (TEG) nutzbar werden, um die bei der Verbrennung fossiler Brennstoffe anfallenden Treibhausgasemissionen dazu zu verwenden, an anderer Stelle Treibhausgase einzusparen und somit den steigenden Anforderungen an den Umwelt- und Klimaschutz gerecht zu werden. Hierzu wird mit Hilfe eines Thermoelektrischen Generators die Abwärme aus Verbrennungsprozessen, z.B. Industrieanlagen, Automobilen, Privathaushalten, usw. in elektrische Energie umgewandelt und steht damit der weiteren Verwendung als Energiequelle zur Verfügung.

Es gibt thermoelektrische Generatoren, beispielsweise Lichtmaschinen im Auto. Auch in Industrieanlagen und Privathaushalten wird verstärkt probiert, ungenutzte Abwärmen mit Hilfe der thermoelektrischen Generatoren nutzbar zu machen und als sekundäre Energiequelle zu etablieren.

Bestehende thermoelektrische Generatoren weisen eine bestimmte Anzahl Thermoschenkel mit einer gewissen Fläche auf, die meist aus intermetallischen Materialien sind. Die thermoelektrischen Generatoren sind dabei meist in der Form von kaskadierten Einzelmodulen aufgebaut.

Dabei werden beispielsweise nanometerdünne Lagen aus thermoelektrisch unterschiedlich aktivem Material aufeinander gelegt.

Für die notwendige Kaskadierung von thermoelektrischen Elementen hat die Freiburger Firma Micropelt die einzelnen Elemente verkleinert und kann so bereits eine hohe Spannungsausbeute pro Fläche erzielen. Weitere thermoelektrische Generatoren sind von der Firma EnOcean aus Oberhaching sowie von dem Fraunhoferinstitut in Erlangen bekannt.

EP 1 515 376 A2 (MILIAUSKAITE ASTA DR [DE]) 16. März 2005 offenbart einen thermoelektrischen Generator, ein oder mehrere Stacks aus waagrecht angeordneten Schichten mit dazwischen senkrecht verlaufenden Kanälen umfassend.

Problematisch bei den bislang aufgebauten thermoelektrischen Generatoren ist neben dem Design immer auch das Problem, dass die Materialien mit hoher thermoelektrischer Umwandlungseffizienz meist extrem giftige Bestandteile wie Arsen, Thallium, Bleitellurid und/oder sehr teure Komponenten wie Platin haben.

Es besteht daher immer der Bedarf, neue thermoelektrische Generatoren zu schaffen, die sowohl vom Layout und der Schaltung der Module als auch vom Material her die Nachteile des Standes der Technik überwinden.

Aufgabe der vorliegenden Erfindung ist es deshalb, einen thermoelektrischen Generator zu schaffen, der bei einer kompakten Bauweise eine hohe Energiedichte hat, vom Layout und/oder der Schaltung der Module her möglichst flexibel gestaltet werden kann und mit möglichst ungiftigen Materialien kostengünstig und massenfertigungstauglich herstellbar ist.

Lösung der Aufgabe und Gegenstand der Erfindung ist daher ein thermoelektrischer Generator, ein oder mehrere Stacks aus waagrecht angeordneten Schichten mit dazwischen senkrecht verlaufenden Kanälen umfassend, wobei die Schichten eine Schichtabfolge von p-halbleitender und n-halbleitender Schicht mit dazwischen einer isolierenden Schicht aufweisen, wobei immer zwei aufeinanderfolgende halbleitende Schichten über die isolierende Schicht hinweg elektrisch verbunden sind, so dass ein Stromfluss infolge Thermodiffusion nur in waagrechter Richtung entlang des Temperaturgradienten innerhalb einer halbleitenden Schicht erfolgt, wobei die senkrecht verlaufenden Kanäle abwechselnd warme und kalte Luft führen, so dass innerhalb der halbleitenden Schichten ein Temperaturgradient entsteht.

Die halbleitenden Schichten umfassen eine Trägermatrix, in die plättchenförmige Partikel wie Glimmer, eingearbeitet sind, die die halbleitende Eigenschaft der Schicht bewirken. Die Schicht wird dann beispielsweise im Dickschichtverfahren hergestellt.

Beispielsweise sind die Partikel aus keramischem Material, das halbleitfähig beschichtet ist.

Beispielsweise sind die Partikel aus Glimmer oder einem oxidischen Material, das eine geringe Wärmeleitfähigkeit hat.

Diese Partikel werden dann mit einem halbleitenden Oxidgemisch beschichtet, so dass die Einarbeitung in eine Trägermatrix dieser zu einer n- oder p-Leitfähigkeit verhilft. Die Anwendung oxidischer Halbleitermaterialien in thermoelektrischen Generatoren bewirkt eine Verbesserung der Effizienz und Umweltverträglichkeit dieser Systeme.

Nach einer bevorzugten Ausführungsform wird zur Herstellung einer Schicht die Trägermatrix mit halbleitfähigen Partikeln als Beschichtung auf ein Substrat wie eine Folie, Gewebe, ein Band und/oder Keramiksubstrate aufgebracht.

Die einzelnen Schichten des Schichtaufbaus haben beispielsweise eine Schichtdicke von kleiner 300µm.

Nach einer weiteren Ausführungsform liegen die Partikel in multimodaler Verteilung, mit verschiedener Partikelgröße und/oder Partikelform in der Trägermatrix vor.

Nach einer bevorzugten Ausführungsform haben die Partikel ein großes Aspektverhältnis, sie liegen bevorzugt plättchenförmig vor.

Die Partikel aus teilleitfähigen Materialien sind beispielsweise Partikel auf der Basis von Oxidkeramiken, insbesondere von dotierten Oxidkeramiken, die sich aufgrund ihrer hohen elektrischen Leitfähigkeit und/oder niedrigen thermischen Leitfähigkeit eignen.

Ein Aufbau aus gemäß der Erfindung beispielsweise beschichteten Flächenwerkstoffen als Substraten (Schichtdicke einer einzelnen Schicht beispielsweise kleiner 300 Mikrometer) weist ein elektrisches Potenzial auf, da die notwendige Kontaktierung der leitfähigen Schichten *via*-artig (*via* = Durchkontaktierung) erfolgen kann, wodurch zugleich Durchströmungskanäle für die heißen Gase entstehen. Diese Strömungskanäle können in Form und Dimension so ausgelegt werden, dass die im erwärmten Luftstrom zur Verfügung stehende Energie effizient an den TEG übertragen wird.

Als Trägermatrix dienen Harze allgemein, insbesondere Epoxidharze, Lacke und/oder Bänder.

Beim Einbringen der beschichteten Partikel in die Trägermatrix wird diese bevorzugt mit einem Lösungsmittel versetzt, wodurch beim Verdunsten des Lösungsmittels in der Trägermatrix Konvektionsströme sich ausbilden, mit denen die Partikel in der Trägermatrix ausgerichtet werden. Dies führt vorteilhaft zu einer optimalen Kontaktierung der Partikel untereinander. Des Weiteren ist durch die planare Geometrie der Partikel ein unerwünschtes Sedimentieren der Partikel in der Trägermatrix erzielt.

Die Partikelmassenkonzentration der Partikel in der Trägermatrix wird derart gewählt dass das Schichtmaterial oberhalb der Perkulationsschwelle ist.

Hierbei ist es bevorzugt, dass die Partikelmassenkonzentration der Partikel bei mehr als 25 Gew.% liegt Ab dieser bestimmten Partikelmassenkonzentration in der Trägermatrix befindet sich das Schichtmaterial oberhalb der Perkulationsschwelle und der Oberflächenwiderstand des Schichtmaterials ändert sich kaum mit steigender Partikelmassenkonzentration. Dadurch unterliegt das Schichtmaterial kaum Schwankungen im Oberflächenwiderstand, der dadurch gut reproduzierbar ist.

Die Partikel sind bevorzugt aus Glimmer, Siliziumcarbid, einem undotiertem Metalloxid, insbesondere Aluminiumoxid. Durch die planare Struktur der Partikel wird eine verbesserte Kontaktierung der teilleitfähigen Partikel untereinander erreicht. Bevorzugtermaßen wird das die Partikel beschichtende Metalloxid aus der Gruppe gewählt: Metalloxid in binärer und tertiärer Mischphase, insbesondere Zinnoxid, Zinkoxid, Zinkstannat, Titanoxid, Bleioxid, Siliziumcarbid. Als Dotierungselement für den n-Typ wird bevorzugt eines aus der Gruppe Antimon, Indium, Cadmium gewählt.

Die plättchenförmigen teilleitfähigen Partikel führen aufgrund ihres großen Aspektverhältnisses über einen größeren Konzentrationsbereich zu einer Perkolation, so dass es mit Hilfe der Beschichtungen möglich ist, die für einen großen thermoelektrischen Effekt benötigten Leitfähigkeiten für n- und p-Halb- oder Teilleiter einzustellen.

Neben der Form der Partikel kommt ihrer Beschichtung eine zentrale Bedeutung für die elektrische Leitfähigkeit zu. Durch exakte Applikation der dotierten Metalloxide und deren Dotierung ist eine definierte Einstellung der elektrischen Leitfähigkeit möglich.

Daraus ergibt sich für das erfindungsgemäße System eine Reihe von technischen Vorteilen:
- Gute Trennung von elektrischer Leitfähigkeit (hoch) und Wärmeleitfähigkeit (niedrig), wie für thermoelektrische Generatoren angestrebt verbunden mit
- hoher Designfreiheit.

Durch eine thermische Parallel- und eine elektrische Serienschaltung der erfindungsgemäßen Einzelmodule lässt sich ein thermoelektrischer Generator mit einer für den kommerziellen Einsatz nutzbaren Leerlaufspannung fertigen.

Es erfolgt eine Verbesserung des Formfaktors, da oxidische Halbleiter, die in eine Trägermatrix eingebettet sind, als Beschichtung auf isolierende Flächenwerkstoffe aufgebracht werden, es ergeben sich Freiheitsgrade in der Produktion entsprechender Systeme.

Schließlich ergibt sich eine effiziente Einstellung der Temperaturgradienten durch große Oberflächen, z. B. mit porösen Keramikmaterialien.

Nach der Erfindung ergibt sich eine einfache elektrische Kaskadierung von Einzelmodulen mittels Schichttechnologien.

Eine hohe Wirtschaftlichkeit wird durch geringe Materialkosten und durch den Einsatz kommerziell verfügbarer Substratwerkstoffe erreicht.

Beispielsweise ist an den Einsatz von Nano-Beschichtungstechnologien zur effizienten Abscheidung der oxidischen Halbleitermaterialien gedacht.

Gesinterte Keramikmaterialien, stellen seit Jahrzehnten die Basis von (Kraftfahrzeug-) Katalysatoren dar.

Ein Vorteil ist die Applikation von p- und n-Halbleiterstrukturen und/oder -beschichtungen in einer Trägermatrix für Niedertemperaturanwendungen (< 250 °C).

Die Kombination der aufgelisteten Erfolgsfaktoren ermöglicht eine wirtschaftliche Anwendung von TEGs auch bei niedrigen Temperaturen (< 250°C), wie sie typischerweise in Abgasschloten auftreten.

Bei den oxidischen Materialen der halbleitenden Schichten handelt es sich bevorzugt um Oxidgemische. In Tabelle 1 sind beispielhaft verschiedene Typen und Zusammensetzungen halb- oder teilleitender Oxidgemische aufgeführt.

**Tabelle 1: Auswahl unterschiedlicher Zusammensetzungen halb oder teilleitender Oxidgemische für Thermoelektrische Generatoren.**

| P-Typ | n-Typ |
|---|---|
| (Ca_{2.8} Co₄ Na_{0.2} Oₓ) | (La₁₋ₓ Srₓ) FeO₃ |
| (Bi_{0.3}Ca_{3.4}Co₄Oₓ) | Ca₁₋ₓMₓMnO₃ |
| (Ca_{3.4}Co₄Na_{0.2}Oₓ) | ZnO/In₂O₃ |
| (Bi_{0.3}Ca_{2.8}Co₄Oₓ) | (ZnO)ₘIn₂O₃ |
| (CoNi)As₃) | CuFe₁₋ₓNiₓO₂. |
| Ca₂Co₂O₅ | (CoNi)As₃) |
| Ca₃Co₄O₉ | (YbFe₂O₄ |
| Bi₂Sr₂₋ₓLaₓCo₂O₉ | Sb dotiertes SnO₂ |
| Bi _{2-y} Sn_{y}Sr₂Co₂O₉ | Titanate |
| | Stannate |

Darüber hinaus sind p-leitende Cuprite bekannt, wie CuAlO₂, CuCrO₂, CuCr₁₋ₓAlₓO₂ oder auch andere Kupferverbindungen wie CuSCN, die gemäß der Erfindung als teilleitfähige Materialien in Betracht kommen.

Im Folgenden wird die Erfindung noch anhand von beispielhaften Ausführungsformen näher beschrieben:
- Figur 1: zeigt eine schematische Seitenansicht eines TEG aus Einzelmodulen auf Basis halb- oder teilleitender und isolierender Schichten,
- Figur 2: zeigt eine Draufsicht auf einen TEG mit Schichtstruktur und runden Durchkontaktierungen,
- Figur 3: zeigt eine weitere Draufsicht auf einen TEG mit Schichtstruktur und schlitzförmigen Durchkontaktierungen
- Figur 4: zeigt eine schematische Seitenansicht eines TEG-Moduls mit schlitzförmiger Kanalgeometrie und
- Figur 5: zeigt eine schematische Seitenansicht eines TEG bei dem die halb- oder teilleitenden Schichten mit Hilfe der Rakeltechnik aufgebracht wurden.

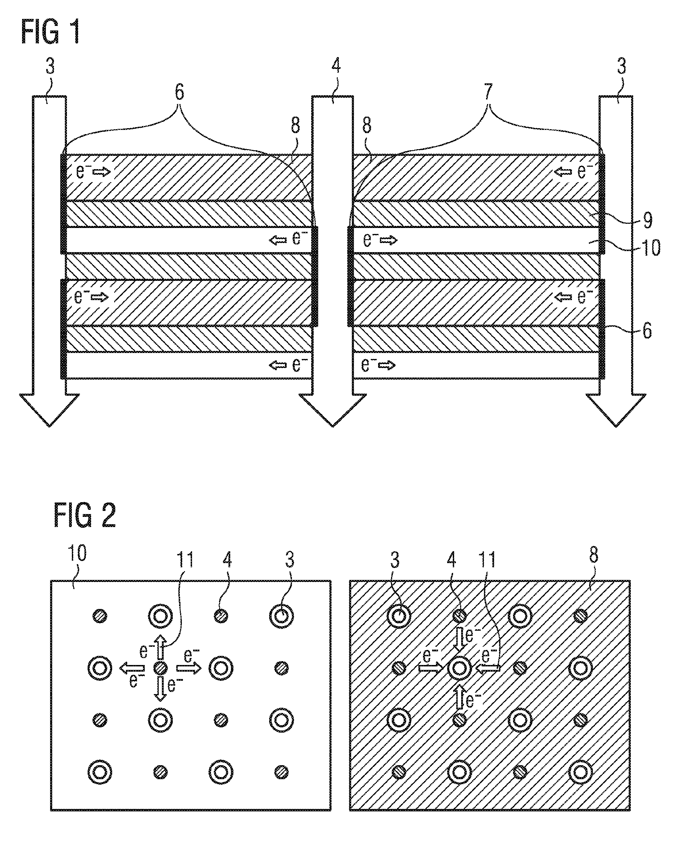

Figur 1 zeigt einen thermoelektrischen Generator (TEG) in der schematischen Seitenansicht. Zu erkennen sind zwei aus einzelnen Schichten 8 bis 10 bestehende Blöcke 1 und 2 an deren Seiten drei mit Luft durchflossene Kanäle angeordnet sind, wobei die äußeren Kanäle 3 Kaltluft und der innere Kanal 4 Warmluft führt. In den Kanälen 3,4 sind die elektrischen Kontaktierungen (Vias) 6 und 7 angeordnet. Im Betrieb durchfließt beispielsweise warme Luft den Kanal 4 und kalte Luft die Kanäle 3. Dadurch wandern in der p-dotierten Schicht 8 Ladungsträger, also beispielsweise Elektronen, innerhalb der Schicht entlang des Temperaturgradienten von kalt nach warm, im gezeigten Fall also von den Kanälen 3 weg zur Mitte hin Richtung Kanal 4.

Unterhalb der p-dotierten Schicht 8 liegt vollflächig die isolierende Schicht 9, in der keine Wanderung von Ladungsträgern stattfindet. Unterhalb der isolierenden Schicht 9 liegt die n-dotierte Schicht 10, in der ebenfalls eine Ladungsträgerwanderung innerhalb der Schicht, allerdings in entgegen gesetzter Richtung von warm nach kalt stattfindet.

Jeder Block hat den gleichen Aufbau und auf einer Ebene liegen beispielsweise die gleichen Schichten 8,9 oder 10. Dies kann im Einzelfall auch anders gelöst sein. Die elektrischen Kontaktierungen 6 und 7 verbinden, voneinander getrennt geführt, zum einen im warmen Bereich die n-dotierte Schicht 10 mit der p-dotierten Schicht 8 und zum anderen im kalten Bereich die gleiche, beispielsweise n-dotierte Schicht 10 mit der nächsthöheren oder nächsttiefergelegenen p-dotierten Schicht 8. So kann Strom durch die einzelnen Module fließen.

Die einzelnen Schichten 8 bis 10 sind bevorzugt dünnste Schichten beispielsweise mit Schichtdicken von unter 300 Mikrometern.

Figur 2 zeigt eine Draufsicht auf die einzelnen Schichten, links auf eine n-dotierte Schicht 10 und rechts auf eine p-dotierte Schicht 8. Innerhalb der Schicht sind die Kanäle 3 bis 5 und weitere Kanäle eingezeichnet, die in Figur 1, da diese Figur ein Detail einer Seitenansicht zeigt, nicht sichtbar sind.

Innerhalb der n-dotierten Schicht 10 (links in Figur 2 gezeigt), ist durch Pfeile 11 die Wanderung der Ladungsträger innerhalb der Schicht von warm, also von dem Bereich um den warme Luft führenden Kanal 4 nach kalt, also die Bereiche um Kaltluft-Kanäle 3, gezeigt. Die Querschnitte der Kanäle 3 sind hier beispielsweise rund ausgebildet.

Innerhalb der p-dotierten Schicht 8 (rechts in Figur 2 gezeigt), ist durch Pfeile 11 die Wanderung der Ladungsträger von kalt, also dem Bereich um die Kaltluft-Kanäle 3, nach warm, also den Bereich um die Warmluft-Kanäle 4, gezeigt. Hier findet demnach eine Spannungserzeugung infolge der auf unterschiedlichen Temperaturen liegenden Strömungskanäle statt.

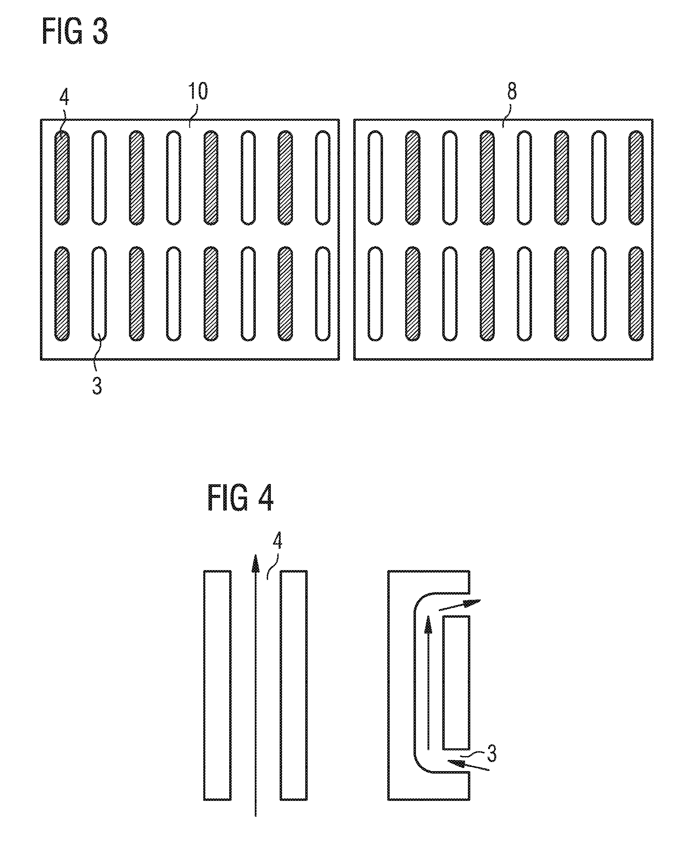

Weiterhin können die Strömungskanäle 3 bis 5 nicht nur runde Geometrien aufweisen, sondern auch z.B. schlitzförmig sein, wie in den Figuren 3 und 4 schematisch dargestellt. Besonders vorteilhaft ist hier, dass in den Kaltluftkanälen 3, 5 der Kamineffekt ausgenutzt wird, um frische Kühlluft in die TEG-Module zu ziehen. Hierbei tritt erwärmte Kaltluft oben aus den Kanälen aus und zieht dadurch von unten frische Kaltluft in das System hinein.

Figur 3 zeigt eine mit Figur 2 vergleichbare Draufsicht, wobei die schlitzförmigen Strömungskanäle 3 und 4 wieder abwechselnd in der Schicht angeordnet sind. Der Übersichtlichkeit halber wurde auf die Darstellung der Pfeile 11, die immer in der links dargestellten n-dotierten Schicht 10 von den warmen Kanälen 4 zu den kalten Kanälen 3 wandern und in der rechts dargestellten p-dotierten Schicht 8 in umgekehrter Richtung von Kanälen 3 nach Kanälen 4, verzichtet.

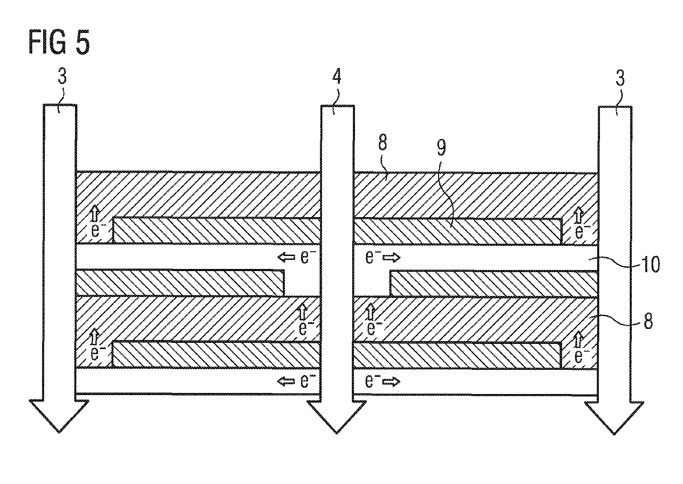

Figur 4 zeigt in der Seitenansicht einen Ausschnitt einer Seitenansicht gemäß der Figuren 1 und 5, wobei schlitzförmige Kanalgeometrien gezeigt werden: links ist ein Heißluftkanal 4 und rechts ein Kaltluft-Kanal 3 mit Kamineffekt dargestellt.

Figur 5 zeigt wieder eine der Figur 1 vergleichbare Seitenansicht eines ganzen Moduls mit zwei Blöcken 1,2 aus vielen Schichten 8 bis 10, allerdings ist der Schichtaufbau verschieden von dem in Figur 1 gezeigten. Hier werden die einzelnen Schichten, insbesondere die Halbleiterschichten, durch Rakeltechnik aufgebracht. So können die elektrischen Kontaktierungen 6 und 7 durch einfache Strukturierung der isolierenden Schichten und darauffolgendes Einrakeln einer dotierten Schicht, so dass sie an einer Stelle in direktem elektrischen Kontakt mit der nächsten entgegengesetzt dotierten Schicht kommt, ersetzt werden. In Figur 5 ist der Gang der Ladungsträger, also beispielsweise der Elektronen, durch Pfeile 11 angezeigt.

Die in den in den Figuren gezeigten Ausführungsbeispiele stellen schematisch dar, dass im Schichtaufbau die halb- oder teilleitende Schichten 8 und 10 durch elektrisch isolierende Schichten 9 voneinander getrennt sind, so dass ein Stromfluss 11 infolge von Thermodiffusion nur in horizontaler Richtung (entlang des Temperaturgradienten) möglich ist. Die halb- oder teilleitenden Schichten 8 und 10 werden aus Flächenwerkstoffen wie Folien, Geweben und Keramiksubstraten oder mittels Dickschichttechnologie realisiert. Hierbei kommen beschichtete teilleitfähige Partikel zum Einsatz.

Im Gegensatz zum Stand der Technik weisen die gezeigten Module eine große Designfreiheit auf und eröffnen dadurch das Potenzial, die Energie eines großvolumigen Abgasstroms mit einer Temperatur im Bereich von 150°C effizient auf einen Thermoelektrischen Generator zu übertragen und somit in elektrische Energie umzuwandeln. Durch eine thermische Parallel- und eine elektrische Serienschaltung der beschriebenen Einzelmodule lässt sich ein kostengünstiger Thermoelektrischer Generator mit einer kommerziell verwertbaren Leerlaufspannung realisieren.

Die Module können auf Basis kunststoffgebundener, halb- oder teilleitfähiger Materialien hergestellt werden. Dabei weisen oxidische Halbleitermaterialien im Gegensatz zu metallischen Materialien entsprechend dem Stand der Technik (Bi₂Te₃, PbTe, SiGe, BiSb, ...) großes Potenzial hinsichtlich folgender Aspekte ein auf:
- Verbesserung der thermoelektrischen Gütezahl Z und damit des Wirkungsgrades eines TEG
- Reduktion der Wärmeleitfähigkeit (bei oxidischen Keramiken deutlich geringer als bei Metallen).
Ideale Materialpaarung (keramische p- und n-Halbleiter) lassen sich maßschneidern, um den thermoelektrischen Effekt zu vergrößern.

Die Erfindung betrifft einen thermoelektrischen Generator, insbesondere einen zur Nutzung der Abwärme von Abgasen mit einer Temperatur kleiner 250°C, wie sie beispielsweise in der Kraftwerkstechnologie anfallen. Dabei kommen teilleit- oder halbleitfähig beschichtete Partikel zum Einsatz, die schichtförmig angeordnet zwischen Heiß- und Kaltluftkanälen zu einem nutzbaren Stromfluss führen.

## Patentansprüche

1. Thermoelektrischer Generator, ein oder mehrere Stacks aus waagrecht angeordneten Schichten (8,9,10) mit dazwischen senkrecht verlaufenden Kanälen (3, 4) umfassend, wobei die Schichten (8, 9, 10) eine Schichtabfolge von p-halbleitender (8) und n-halbleitender (10) Schicht mit dazwischen einer isolierenden Schicht (9) aufweisen, wobei immer zwei aufeinanderfolgende halbleitende Schichten (8,10) über die isolierende Schicht (9) hinweg elektrisch verbunden sind, so dass ein Stromfluss (11) infolge Thermodiffusion nur in waagrechter Richtung entlang des Temperaturgradienten innerhalb einer halbleitenden Schicht (8, 10) erfolgt, wobei die senkrecht verlaufenden Kanäle (3,4) abwechselnd warme und kalte Luft führen, so dass innerhalb der halbleitenden Schichten (8, 10) ein Temperaturgradient entsteht,
**dadurch gekennzeichnet, dass** die halbleitenden Schichten (8,10) eine Trägermatrix, die ein Harz ist mit plättchenförmigen Partikel, die mit einem dotierten Oxid beschichtet sind, umfassen, die in einer Konzentration oberhalb der Perkulationsschwelle in der Trägermatrix vorliegen.

2. Thermoelektrischer Generator nach Anspruch 1, wobei die Partikel aus teilleitfähigem Material sind.

3. Thermoelektrischer Generator nach einem der Ansprüche 1 oder 2, wobei die Partikel in einer Partikelmassekonzentration von mehr als 25 Gew% vorliegen.

4. Thermoelektrischer Generator nach einem der vorstehenden Ansprüche, wobei die Partikel mit Hilfe von Lösungsmittel in die Trägermatrix eingebracht werden.

5. Thermoelektrischer Generator nach einem der vorstehenden Ansprüche, wobei die oxidischen Verbindungen der Beschichtung der Partikel der p-halbleitenden Schicht ausgewählt sind aus der Gruppe folgender Verbindungen:
(Ca_{2.8}Co₄ Na_{0.2}Oₓ) ; (Bi_{0.3}Ca_{3.4}Co₄Oₓ) ; (Ca_{3.4}Co₄Na_{0.2}Oₓ) ; (Bi_{0.3}Ca_{2.8}Co₄Oₓ) ; (CoNi)As₃; Ca₂Co₂O₅; Ca₃Co₄O₉; Bi₂Sr₂₋ₓLaₓCo₂O₉; Bi_{2-y}Sn_{y}Sr₂Co₂O₉; CuAlO₂, CuCrO₂, CuCr₁₋ₓAlₓO₂ und/oder CuSCN.

6. Thermoelektrischer Generator nach einem der vorstehenden Ansprüche, wobei die oxidischen Verbindungen der Beschichtung der Partikel der n-halbleitenden Schicht ausgewählt sind aus der Gruppe folgender Verbindungen: (La₁₋ₓ Srₓ) FeO₃; Ca₁₋ₓMₓMnO₃; ZnO/In₂O₃ ; (ZnO)ₘIn₂O₃; CuFe₁₋ₓNiₓO₂ ; (CoNi)As₃) ; (YbFe₂O₄; Sb dotiertes SnO₂; Titanate und Stannate.

7. Thermoelektrischer Generator nach einem der vorstehenden Ansprüche, wobei die Trägermatrix ausgewählt ist aus der Gruppe folgender Harze: Epoxidharze, Lacke und/oder Bänder.

## Claims

1. Thermoelectric generator comprising one or more stacks formed from horizontally arranged layers (8, 9, 10) having channels (3, 4) extending vertically in between, wherein the layers (8, 9, 10) is a sequence of a p-type semiconducting layer (8) and an n-type semiconducting (10) layer with an insulating layer (9) sandwiched therebetween, wherein in each case two successive semiconducting layers (8, 10) are electrically connected across the insulating layer (9) so that a current flow (11) due to thermal diffusion is possible only in the horizontal direction along the temperature gradient inside a semiconducting layer (8, 10), wherein the vertically extending channels (3, 4) duct warm and cold air alternately with the result that a temperature gradient is produced inside the semiconducting layers (8, 10),
**characterised in that** the semiconducting layers (8, 10) include a support matrix which is a resin having platelet-like particles coated with a doped oxide, which are present in the support matrix in a concentration above the percolation threshold.

2. Thermoelectric generator according to claim 1, wherein the particles are made of a partially conducting material.

3. Thermoelectric generator according to one of claims 1 or 2, wherein the particles are present in a particle-mass concentration of more than 25 wt%.

4. Thermoelectric generator according to one of the preceding claims, wherein the particles are incorporated into the support matrix with the aid of a solvent.

5. Thermoelectric generator according to one of the preceding claims, wherein the oxidic compounds for coating the particles in the p-type semiconducting layer have been selected from the group of following compounds:
(Ca_{2.8}Co₄Na_{0.2}Oₓ); (Bi_{0.3}Ca_{3.4}Co₄Oₓ); (Ca_{3.4}Co₄Na_{0.2}Oₓ); (Bi_{0.3}Ca_{2.8}Co₄Oₓ) ; (CoNi)As₃) ; Ca₂Co₂O₅; Ca₃Co₄O₉; Bi₂Sr₂₋ₓLaₓCo₂O₉; Bi_{2-y}Sn_{y}Sr₂Co₂O₉; CuAlO₂, CuCrO₂, CuCr₁₋ₓAlₓO₂, and/or CuSCN.

6. Thermoelectric generator according to one of the preceding claims, wherein the oxidic compounds for coating the particles of the n-type semiconducting layer have been selected from the group of following compounds:
(La₁₋ₓ Srₓ) FeO₃; Ca₁₋ₓMₓMnO₃; ZnO/In₂O₃; (ZnO)ₘIn₂O₃; CuFe₁₋ₓNiₓO₂; (CoNi)As₃) ; (YbFe₂O₄; Sb-doped SnO₂; titanates and stannates.

7. Thermoelectric generator according to one of the preceding claims, wherein the support matrix has been selected from the group of following resins: epoxy resins, varnishes and/or tapes.

## Revendications

1. Générateur thermoélectrique comprenant une ou plusieurs piles de couches (8, 9, 10) disposées horizontalement comportant, entre ces piles, des conduits (3, 4) s'étendant verticalement, où les couches (8, 9, 10) présentent une suite de couches comprenant une couche semi-conductrice (8) de type p et une couche semi-conductrice (10) de type n et ayant entre celles-ci une couche isolante (9), où deux couches (8, 10) semi-conductrices qui se suivent sont toujours reliées électriquement par la totalité de la couche isolante (9), de sorte qu'un flux de courant (11) se produit par thermodiffusion seulement dans la direction horizontale le long du gradient de température à l'intérieur d'une couche semi-conductrice (8, 10), où les conduits (3, 4) s'étendant verticalement acheminent alternativement de l'air chaud et froid, de sorte qu'il se produit un gradient de température à l'intérieur des couches semi-conductrices (8, 10),
**caractérisé en ce que** les couches semi-conductrices (8, 10) comprennent une matrice de support qui est une résine ayant des particules en forme de plaquettes qui sont enduites d'un oxyde dopé, particules qui sont présentes dans la matrice de support, suivant une concentration supérieure au seuil de percolation.

2. Générateur thermoélectrique selon la revendication 1, où les particules se composent d'un matériau partiellement conducteur.

3. Générateur thermoélectrique selon l'une des revendications 1 ou 2, où les particules sont présentes suivant une concentration de masse de particules de plus de 25 % en poids.

4. Générateur thermoélectrique selon l'une quelconque des revendications précédentes, où les particules sont introduites dans la matrice de support, à l'aide d'un solvant.

5. Générateur thermoélectrique selon l'une quelconque des revendications précédentes, où les composés oxydiques du revêtement des particules de la couche semi-conductrice de type p sont choisis dans le groupe de composés suivants : (Ca_{2,8}Co₄ Na_{0,2}Oₓ) ; (Bi_{0,3}Ca_{3,4}Co₄Oₓ) ; (Ca_{3,4}Co₄Na_{0,2}Oₓ); (Bi_{0,3}Ca_{2,8}Co₄Oₓ) ; (CoNi)As₃) ; Ca₂Co₂O₅; Ca₃Co₄O₉; Bi₂Sr₂₋ₓLaₓCo₂O₉; Bi_{2-y}Sn_{y}Sr₂Co₂O₉; CuAlO₂, CuCrO₂, CuCr₁₋ₓAlₓO₂ et/ou CuSCN.

6. Générateur thermoélectrique selon l'une quelconque des revendications précédentes, où les composés oxydiques du revêtement des particules de la couche semi-conductrice de type n sont choisis dans le groupe de composés suivants : (La₁₋ₓ Srₓ) FeO₃; Ca₁₋ₓMₓMnO₃; ZnO/In₂O₃; (ZnO)ₘIn₂O₃; CuFe₁₋ₓNiₓO₂; (CoNi)As₃); (YbFe₂O₄; SnO₂ dopé au Sb; titanates et stannates.

7. Générateur thermoélectrique selon l'une quelconque des revendications précédentes, où la matrice de support est choisie dans le groupe de résines suivantes : résines époxydes, vernis et/ou bandes.
